# EUROPÄISCHE PATENTANMELDUNG

(11) **EP 4 517 687 A1**
(43) Veröffentlichungstag der Anmeldung: **05.03.2025**
(21) Anmeldenummer: 23194601.3
(22) Anmeldetag: 31.08.2023
(51) Int. Cl.: G06V 10/764, B60L 58/16, G01R 31/392, G06V 20/52, H01M 10/48, G01R 31/367

(54) **ZUSTANDSABHÄNGIGE HANDHABUNG EINER UNGEÖFFNETEN BATTERIE**

(71) Anmelder: Siemens Aktiengesellschaft, 80333 München (DE)
(72) Erfinder: Baldauf, Manfred, 91056 Erlangen (DE); Chakroun, Zied, 90491 Nürnberg (DE); Franke, Martin, 14089 Berlin (DE); Kumar, Avinash, 81379 München (DE); Pol, Sebastian, 90556 Seukendorf (DE); Schmid, Arthur, 80337 München (DE); Schulte, Sascha, 91315 Höchstadt (DE); Krubasik, Edward Cornelius, 80809 München (DE); Loskyll, Matthias, 92318 Neumarkt (DE); Taubensee, Sebastian, 04416 Markkleeberg (DE)
(74) Vertreter: Siemens Patent Attorneys

(57) **Zusammenfassung**

Die Erfindung betrifft ein Verfahren zur zustandsabhängigen Handhabung einer Batterie mit einer berührungslosen und optischen Erfassung der Batterie in einem ungeöffneten Zustand durch ein Erfassungsgerät und Erstellung eines optischen Datensatzes, mit einer computergestützten Verarbeitung des optischen Datensatzes durch ein Bildverarbeitungssystem auf Basis eines Referenzdatensatzes eines Äußeren der Batterie zur Erstellung einer Bewertung eines Zustands der Batterie, und mit einem Ausgeben der Bewertung des Zustands zum Ableiten einer Handlungsempfehlung für die Handhabung der ungeöffneten Batterie, sowie eine zugehörige Steuerungseinheit.

## Beschreibung

Die Erfindung betrifft ein Verfahren zur zustandsabhängigen Handhabung einer Batterie mit einer berührungslosen und optischen Erfassung der Batterie in einem ungeöffneten Zustand durch ein Erfassungsgerät sowie eine zugehörige Steuerungseinheit.

Batterien für den Gebrauch in Antriebssystemen in der Industrie und im Endanwenderumfeld nehmen weiterhin an Bedeutung zu. Entsprechend wächst auch die Bedeutung eines möglichst umfänglichen Recyclings von Batterien. Speicherbatterien für Elektrofahrzeuge und ähnliche Anwendungen werden nach Ablauf ihrer regulären Lebensdauer für ein Recycling geöffnet und zerlegt. Zudem werden Batterien während der vorgesehenen Lebensdauer außerplanmäßig zu Reparaturzwecken geöffnet. In diesen und ähnlichen Fällen ist es möglich, dass die Batterie vorgeschädigt oder durch eine Vorschädigung intern vollständig zerstört wurde, ohne dass dies von außen offensichtlich erkennbar ist.

Aufgrund der teilweise gefährlichen Stoffe und Materialien, die in den Zellen verbaut sind oder die als Reaktionsprodukt nach einem Brand entstehen können, geht von derartigen Batterien eine latente Gefahr aus. Bei unsachgemäßer Öffnung des normalerweise luftdichten Gehäuses ohne ausreichende Schutzmaßnahmen können diese giftigen Stoffe entweichen oder sich bei Luftzutritt entzünden und eine Gefahr für Personal, Umwelt, und Maschinen darstellen. Weiterhin ist es denkbar, dass im Inneren an nicht dokumentierten Stellen eine lebensgefährliche Spannung in Folge von Isolationsbeschädigungen vorzufinden ist.

Es ist denkbar, den Batteriezustand über das Battery-Management-System, kurz BMS, abzufragen. Wenn dieses noch intakt ist und keine auffälligen Daten liefert, kann angenommen werden, dass die Batterie keine signifikanten internen Defekte hat. Sollte das BMS keine Daten liefern, ist nicht festzustellen, ob lediglich das BMS defekt oder ohne Spannungsversorgung ist oder ob ein schwerwiegender Fehler vorliegt.

Die meisten Batterien für Elektrofahrzeuge, kurz EV-Batterien, sind mit einer sogenannten Venting-Öffnung inklusive einer Berstmembran ausgerüstet. Im Fall eines katastrophalen Fehlers wie eines thermischen Events oder Brandes erzeugen die Reaktionsprodukte oder Abgase in der Batterie einen Überdruck, der die Berstmembran öffnet und ein Entweichen der Abgase durch die Venting-Öffnung erlaubt.

Das Vorfinden einer geöffneten Berstmembran oder Berstscheibe ist daher ein guter, aber nicht hinreichender Hinweis auf schwere Komplikationen. Es kann auch Fehler geben, bei denen sehr langsame Brände keinen oder nur geringe Überdrücke erzeugt haben.

Ferner gibt es Batterien, bei denen die Venting-Öffnung nicht durch eine Berstmembran geschützt ist, so dass dieser Indikator entfällt.

Überdies lässt sich eine defekte Isolation ohne massive Folgereaktionen über die Berstmembran oder Venting-Öffnung nicht detektieren.

Vor diesem Hintergrund ist es eine Aufgabe der vorliegenden Erfindung eine Handhabung einer ungeöffneten Batterie adaptiv und insbesondere sicher zu gestalten. Diese Aufgabe wird durch die Merkmale der unabhängigen Ansprüche gelöst. Vorteilhafte Ausgestaltungen sind in den abhängigen Ansprüchen angegeben.

Die Erfindung betrifft ein Verfahren zur zustandsabhängigen Handhabung einer Batterie, aufweisend folgende Schritte:
- berührungslose und optische Erfassung der Batterie in einem ungeöffneten Zustand durch ein Erfassungsgerät und Erstellung eines optischen Datensatzes,
- computergestützte Verarbeitung des optischen Datensatzes durch ein Bildverarbeitungssystem auf Basis eines Referenzdatensatzes eines Äußeren der Batterie zur Erstellung einer Bewertung eines Zustands der Batterie,
- Ausgeben der Bewertung des Zustands zum Ableiten einer Handlungsempfehlung für die Handhabung der ungeöffneten Batterie.

Mit dem vorgeschlagenen Verfahren wird die Batterie in einem ungeöffneten Zustand mittels eines optischen Erfassungsgerätes berührungslos untersucht: Es erfolgt eine berührungslose und optische Erfassung, ohne, dass ein Öffnen der Batterie gefordert wird. Rein aufgrund eines optischen Datensatzes, der das Äußere der Batterie beschreibt, wird eine computergestützte Verarbeitung, insbesondere eine Bildverarbeitung, durchgeführt. Dazu wird ein Referenzdatensatz herangezogen, der ebenfalls das Äußere der Batterie beschreibt.

Vorteilhafterweise werden die Aufnahmen des Erfassungsgerätes mit einer Angabe zur Orientierung der Batterie im Raum versehen, damit der Bildabgleich des optischen Datensatzes mit dem Referenzdatensatz mit möglichst idealen Randbedingungen hinsichtlich Vergleichbarkeit der Orientierung oder Perspektive erfolgt.

Der Referenzdatensatz wird beispielsweise dem Bildverarbeitungssystem von extern bereitgestellt und wird beispielsweise für einen zu untersuchenden Batterietyp spezifisch bereitgestellt. Beispielsweise verfügt das Bildverarbeitungssystem über eine Sammlung der gängigsten Batterietypen, die beispielsweise in einer Recycling- oder Refurbishing- oder Verwertungs-Anlage für Batterien verarbeitet werden. In Alternativen werden dem Bildverarbeitungssystem im Betrieb die passenden Referenzdatensätze bereitgestellt, beispielsweise über eine kabelgebundene oder kabellose Schnittstelle des Datenverarbeitungssystems zu einer Datenbank.

Für eine zu zerlegende Batterie ist üblicherweise bekannt, um welchen Typ es sich handelt. Damit sind auch die Referenzdaten zum Sollzustand, insbesondere Soll-Farbgestaltung, Soll-Dimensionen etc., vorhanden oder abrufbar.

Beispielsweise kann es bei einer Beschädigung der Isolation im Inneren bereits zu Entladungen oder Überschlägen gekommen sein, die durch Veränderungen der Gehäusefarbe, der Gehäuseform oder anhand anderer Unregelmäßigkeiten detektierbar sind. Im Abgleich mit einer Datei, die eine Batterie mit intakter Isolation zeigt, erkennt das Bildverarbeitungssystem Abweichungen vom Normalzustand, die zu einer entsprechenden Bewertung des Zustands der Batterie führen.

Somit kann bereits vor dem Öffnen einer Batterie eine Bewertung des inneren Zustandes hergeleitet werden. Beispielsweise wird so eine Aussage über ein Gefahrenpotenzial von einem unter dem Gehäuse versteckten Brandschaden gegeben. Diese Bewertung wird ausgegeben, beispielsweise über ein HMI des Bildverarbeitungssystems, und wird genutzt um eine Handlungsempfehlung für die Handhabung der ungeöffneten Batterie abzuleiten. Beispielsweise wird dem Wartungs- oder Operator-Personal empfohlen, diese nicht manuell zu öffnen oder nur mit entsprechender Schutzkleidung zu öffnen.

Die Verarbeitung durch ein Bildverarbeitungssystem erfolgt beispielsweise mittels eines Industrie-PCs. Beispielsweise ist dort auch eine Steuerungsfunktionalität im Rahmen einer industriellen Bearbeitungsstation vorgesehen, die einen An- und Abtransport sowie ein Handling der Batterie steuert. Somit lässt sich das Verfahren auch zur zustandsabhängigen Handhabung der Batterie in einen Workflow zum automatisierten Recycling einer Batterie integrieren.

Das Ausgeben der Bewertung erfolgt beispielsweise mittels eines HMIs. Beispielsweise wird die Bewertung anhand einer Skala mit Zuständen von "normal/ ungefährlich" bis "unnormal/ gefährlich" mit möglichen dazwischenliegenden Abstufungen angezeigt. Ferner sind Ausgaben in Textform oder mittels Warnleuchten möglich, die potentiell gefährliche Zustände beschreiben.

Aus der ausgegebenen Bewertung lassen sich manuell oder automatisch Handlungsempfehlungen ableiten und geeignete Handlungen ausführen. Beispielsweise werden automatisch je nach ausgegebener Bewertung bestimmte weitere Aktionen veranlasst, beispielsweise das Zuordnen der potentiell gefährlichen Batterie zu einer Gruppe, die anschließend einer gesonderten Recycling-Maßnahme unterzogen werden. Beispielsweise werden die so identifizierten Batterien maschinell, mittels RoboterGreifarmen, in spezielle Vorrichtungen gelegt und weitertransportiert.

Das Verfahren arbeitet berührungslos, vollautomatisch und schnell. Diese Vorgehensweise ist neben deutlich geringeren Kosten auch mit deutlich reduzierter Gefährdung der Mitarbeiter verbunden, da bei einer traditionellen Prüfung der Batterie durch manuelles Öffnen und "Nachschauen" der Mitarbeiter immer mit ausreichenden Schutzmaßnahmen arbeiten müsste und trotzdem einem Restrisiko ausgesetzt wäre.

Gemäß einer Ausgestaltung weist das Erfassungsgerät einen optischen Sensor, insbesondere eine Kamera, IR-Kamera oder einen 3D Laser Scanner auf. Häufig auftretende Schäden im Inneren einer ungeöffneten Batterie, beispielsweise eine lokale Oxidation, können zuverlässig mit optischen Sensorsystemen wie Kamerasystemen erfasst und mit einer automatischen Bildverarbeitung im Computer erkannt und bewertet werden. Damit erlaubt es diese Methode, ein Batteriesystem berührungslos und sehr schnell, insbesondere innerhalb weniger Sekunden, vollautomatisch zu analysieren.

Gemäß einer Ausgestaltung wird ein Metallgehäuse der Batterie optisch erfasst und der optische Datensatz abhängig von einer Eigenschaft des Metallgehäuses erstellt. Ein großer Teil von Batterieschäden beruht auf internen Bränden oder vergleichbaren thermischen Ereignissen, die zum Platzen von Zellen führen, ohne dass zwingend eine Entzündung eintritt. Bei Bränden beispielsweis aufgrund interner Kurzschlüsse werden lokal oder flächig hohe Temperaturen erreicht. Da die meisten Batteriespeicher mit Metallgehäuse gebaut werden, werden diese von einem lokal begrenzten Brand nicht zerstört, aber verändert. Solche Veränderungen werden mittels der Bildverarbeitung im Abgleich mit dem Referenzbild der Metallgehäuses erkannt.

Der optische Datensatz sowie der Referenzdatensatz umfassen vorzugsweise alle oder zumindest geeignete Ansichten des Metallgehäuses im dreidimensionalen Raum.

Gemäß einer Ausgestaltung wird eine Verfärbung des Metallgehäuses erfasst. Eine typische Reaktion auf hohe Temperaturen an oder in Metallen, wie sie durch lokale thermische Ereignisse im Falle eines Defekts in der Batterie auftreten, ist deren Verfärbung. Diese Verfärbung bleibt auch nach Ende der Erhitzung am kalten Bauteil sichtbar und ist somit detektierbar. Dies wird vorteilhaft ausgenutzt, um den optischen Datensatz mit dem Referenzdatensatz auf Übereinstimmung in der Farbverteilung hin zu untersuchen. Die Verfärbungen weisen beispielsweise eine spezielle Farbfolge oder metallspezifische Farbwerte auf.

Gemäß einer Ausgestaltung wird eine lokale Aufschmelzung des Metallgehäuses erfasst. Beispielsweise treten beim Auftreten lokaler Kurzschlüsse inkl. leistungsstarkem Lichtbogen Gehäuselöcher durch lokale Aufschmelzungen des Metallgehäuses auf. Die Lichtbogenaufschmelzungen weisen charakteristische Eigenschaften des Metalls auf, die rein über optische Erfassung erkannt werden und im Abgleich mit den Referenzdaten auffallen. Insbesondere weisen die Löcher neben einer hitzeinduzierten Verfärbung der Umgebung einen charakteristischen, durch Schmelztropfen geprägten Rand auf.

Gemäß einer Ausgestaltung wird eine geometrische Abmessung der Batterie, insbesondere des Gehäuses, erfasst. Es sind verschiedene Technologien bekannt, mit denen eine computerbasierte Vermessung von Komponenten und Bauteilen auf Basis von Kameradaten und z.B. Laserscannern erfolgt. Diese Technologien erlauben es den Computern, beispielsweise innerhalb von Räumen oder Maschinen die Abmessungen von Subkomponenten zu ermitteln. So ist es beispielsweise möglich, die Länge, Breite oder Höhe eines Gehäuses der Batterie automatisch und berührungsfrei zu messen.

Es erfolgt basierend auf dem Referenzdatensatz ein Sollwertvergleich: Die ermittelten Dimensionen werden mit dem erwarteten Sollwert abgeglichen. Beispielsweise wird die Dicke des Batteriegehäuses geprüft. Bei Überschreiten einer gewissen Grenze kann angenommen werden, dass ein Defekt und ein potenzielles Risiko bestehen, beispielsweise, dass eine BatterieZelle kurz vor dem Bersten steht.

Gemäß einer Ausgestaltung wird eine Wölbung von Bereichen des Metallgehäuses erfasst. Vorteilhafterweise sind bei Analyse der Wölbung keine absoluten Informationen über eine Dicke einer Batterie oder eines Gehäuses notwendig, sondern alleine aus dem Vorhandensein einer Wölbung anstelle einer planen Fläche - wie in einem Referenzdatensatz hinterlegt -, oder einer Wölbung ab einem gewissen Wölbungswinkel, wird auf einen potentiell gefährlichen Zustand der Batterie geschlossen.

Gemäß einer Ausgestaltung ist der Referenzdatensatz des Äußeren der Batterie als eine Datenbank mit Fotos, Kameradaten, Skizzen, über Simulation generierten Bilddaten, 3D-Daten, CAD-Daten und/oder Farbtabellen ausgestaltet. Beispielsweise sind in der Datenbank je Batterietyp ein oder mehrere Arten von Referenzdaten hinterlegt, beispielsweise Fotos und Skizzen. Insbesondere sind die Daten mit einer gewissen Unschärfe hinterlegt, beispielsweise mehrere ähnliche Fotos, insbesondere aufgenommen mit unterschiedlich hoher Auflösung oder unter unterschiedlichen Umgebungsbedingungen.

Gemäß einer Ausgestaltung wird ein machine-learning-basiertes Verfahren basierend auf überwachtem Lernen eingesetzt und eine weitere Bewertung des Zustands der Batterie erstellt. Die Erkennung der optisch erfassbaren Gehäuseveränderungen oder von geänderten und vom Sollzustand abweichenden Farbverläufen kann mittels maschinellen Lernens verstärkt werden.

Gerade für auffallende Verfärbungen, die jedoch von festen Farbmustern, wie sie im Referenzdatensatz hinterlegt sind, abweichen, bringen machine-learning basierte Verfahren Vorteile und erkennen unbekannte Veränderungen.

Dafür wird ein machine-learning System mit gelabelten Daten angelernt. In einer Trainingsphase werden dafür dem machine-learning System Trainings-Daten, die Bilder von gefährlichen Batterien mit äußerlichen, wahrnehmbaren Veränderungen und Bilder von ungefährlichen Batterien mit oder ohne äußerliche, wahrnehmbare Veränderungen jeweils mit einem Label "gefährlich" bzw. "ungefährlich" versehen, vorgegeben. Es erfolgt ein selbstlernender Vergleich mit kritischen und unkritischen Systemen. Über einen selbstlernenden Algorithmus wird verfügbare Fotos oder Scans das Label "unkritisch" oder "kritisch" zugeordnet. Dabei ist "kritisch" immer dann der Fall, wenn eine der Batterien bei oder nach der Zerlegung einen unerwünschten Zustand bis hin zu Bränden eingenommen hat. Dieses Ereignis wird dem lernenden System mitgeteilt und mit dem vorher ermittelten Foto/Scan verknüpft, so dass das selbstlernende System im Laufe der Zeit eine gut/schlecht Basis hat. Beispielsweise wird so ein machine-learning basiertes Verfahren umfassend trainiert, welches dann im realen Betrieb in einem der obigen Verfahren eingesetzt wird.

Beispielsweise werden nach einer entsprechenden Anlernzeit auch optische Veränderungen erkannt, die keine direkte physikalische Erklärung wie die gut dokumentierte Farbveränderung von Metallen haben. Als Beispiel weist eine spezielle Batterie bei einem thermischen Schaden oftmals an einer speziellen Stelle eine Wölbung, induziert durch eine lokale Ausdehnung des erhitzten Metalls, auf, welche als Indikator für das thermische Ereignis genutzt wird. Solche Effekte werden beispielsweise erst durch eine große Anzahl untersuchter Batterien und entsprechend klassifizierter Datensätze, die als Trainingsdaten für das Trainieren des machine-learning basierten Verfahrens verwendet werden, durch den Betrieb des machine-learning basierten Verfahrens selbst erkannt.

Es findet vorzugsweise ein kontinuierlich mitlernendes AI-Verfahren Anwendung, das die Daten aus dem laufenden Betrieb wiederum als Trainingsdaten verwendet. Beispielsweise wird ein neu-lernen in einem vorgegebenen zeitlichen Abstand durchgeführt.

Das Verfahren erkennt dann Fälle, die einerseits nicht dem "ungefährlich"-Zustand aus der Trainingsphase zuzuordnen sind, die aber auch nicht den "gefährlich" gelabelten Daten entsprechen. Das aus der Trainingsphase angelernte Verfahren ist somit zu einer Mustererkennung für unbekannte äußere Veränderungen im laufenden Betrieb fähig.

Somit erfolgt ein Training von Basisdaten auf Basis vieler vorheriger Messungen sowie sogenannten "ground truth"-Daten von Batterien im Neuzustand. Das Training verfeinert die Akzeptanzgrenzen, innerhalb welcher die Entscheidung des AI-Systems für eine bestimmte Bewertung erfolgt.

Gemäß einer Ausgestaltung erfolgt das machine-learning-basierte Verfahren zusätzlich, insbesondere parallel oder nachgeschaltet, zur Erstellung der Bewertung des Zustands der Batterie durch das Bildverarbeitungssystem und es erfolgt ein Ausgeben der Bewertung sowie der weiteren Bewertung des Zustands zum Ableiten einer erweiterten Handlungsempfehlung.

Somit wird vorzugsweise das schnelle, berührungslose Verfahren basierend auf der reinen Bildverarbeitung und dem Abgleich mit dem Referenzdatensatz genutzt. Die Bewertung wird anhand des Referenzdatensatzes auf dem vorgesehenen Weg bereitgestellt, vorzugsweise über HMI Geräte des Bildverarbeitungssystems oder einer Steuerung der Anlage. Zugleich wird das AI-System eingesetzt. Dies wird zeitlich parallel oder nachgeschaltet durchgeführt.

Dieses ermöglicht feinere Analysen und identifiziert insbesondere "false-positives", also irrtümlicherweise durch das Bildverarbeitungssystem als gefährlich eingestufte Batterien, und kennzeichnet diese für ein für die unkritischen Batterien geeignetes Recycling-Verfahren.

Ferner werden durch die AI-gestützten Analysen Muster bei Veränderungen des Äußeren der Batterie erkannt, die nur aufgrund großer zu analysierender Datenmengen erkannt werden und bei Einsatz eines Bewertungssystems auf Basis von Referenzdatensätzen unerkannt blieben, da sie noch unbekannt sind und deshalb noch nicht in Referenzdaten eingegangen sind, oder da sie mit großen Varianzen auftreten, weil beispielsweise die exakten Veränderungen am Farbspektrum oder an den Abmessungen und von vielen äußeren Faktoren abhängen, die eine Mustererkennung durch Experten, welche die Basis für den Referenzdatensatz ist, erschweren.

Vorteilhafterweise ist die Analyse mittels der machine-learning basierten Verfahrens robust gegenüber Kameraaufnahmen, die eine schlechte Qualität aufweisen oder eine unklare Orientierung der Batterie im Raum.

Es wird somit zusätzlich die Bewertung anhand des AI-Verfahrens ermittelt und ausgegeben. Eine erweiterte Handlungsempfehlung berücksichtigt beide Bewertungen und gibt insgesamt die am wenigsten einschränkende zugleich noch als sicher eingestufte Empfehlung für eine weitere Handhabung der Batterie.

In Varianten wird auch die Handlungsempfehlung auf Basis der reinen Bildverarbeitung mit Abgleich mit dem Referenzdatensatz ausgegeben, insbesondere um immer auch die konservativere Abschätzung zu Zwecken der Dokumentation abzulegen.

Es wird gemäß einer Ausgestaltung das Verfahren ferner um folgende Schritte ergänzt:
- Erfassung eines mittels eines Batteriemanagementsystems gespeicherten Betriebszustands-Datensatzes der Batterie,
- computergestützte Verarbeitung des Betriebszustands-Datensatzes durch ein Expertensystem zur Erstellung einer dritten Bewertung eines Zustands der Batterie, wobei die dritte Bewertung in Abhängigkeit von einer Häufigkeit und/ oder Kombination von Betriebszuständen und einem Regelwerk erstellt wird,
- Ausgeben der dritten Bewertung des Zustandes zum Ableiten einer dritten Handlungsempfehlung für eine Handhabung der Batterie.

Neben der bildbasierten Analyse und der entsprechenden Handlungsempfehlung bzw. erweiterten Handlungsempfehlung mit bzw. ohne AI-Unterstützung werden somit vorteilhaft Informationen aus dem Batteriemanagementsystem genutzt, um eine noch bessere und gesichertere dritte Handlungsempfehlung für die weitere Handhabung der Batterie zu erhalten. Somit werden vorteilhaft Informationen, die über eine visuelle Inspektion von äu-ßeren Teilen der Batterie nicht ersichtlich sind, zusätzlich berücksichtigt, um eine Handlungsempfehlung oder erweiterte AI-basierte Handlungsempfehlung um eine dritte Handlungsempfehlung zu ergänzen oder anhand dieser zu korrigieren. Beispielsweise stellt sich durch eine Analyse des Batteriemanagementsystems heraus, dass ein Restwert einer Batterie aufgrund von ungünstigen Entladevorgängen gering ist, obwohl die Bewertung aufgrund der visuellen Inspektion nicht auf Fehlerzustände oder eine besondere Beanspruchung der Batterie hindeutet. Ein Zerlegen und Wiederverwenden würde dann aufgrund der bildbasierten Analyse empfohlen, die durch die Analyse des Batteriemanagementsystems erhaltene dritte Handlungsempfehlung macht jedoch deutlich, dass eine Wiederverwendbarkeit nicht empfohlen wird und ein Zerlegen und Recycling von Einzelteilen zu bevorzugen ist.

Der Betriebszustandsdatensatz wird beispielsweis durch eine Steuerungseinheit, wie beispielsweise einen Industrie-PC mit PLC-Funktionalität, erfasst, sobald dieser mit dem Batteriemanagementsystem der Batterie verbunden ist und Zugriff hat. Beispielsweise sind die auf dem Batteriemanagementsystem gespeicherten Daten mittels kryptographischer Verfahren gesichert und es muss zunächst eine Authentifizierung der Steuerungseinheit erfolgen, bevor dieser Zugriff auf die Daten gegeben wird. Beispielsweise entschlüsselt die Steuerungseinheit die Daten mit einem ihr vorliegenden kryptographischen Schlüssel. Beispielsweise führt die Steuerungseinheit zu Zwecken der Authentifizierung eine kryptographische Funktion aus, um ihre Identität nachzuweisen und erhält dann die Daten in entschlüsselter Form.

Mit dem aus dem Batteriemanagementsystem abgerufenen Betriebszustandsdatensatz führt die Steuerungseinheit eine computergestützte Verarbeitung durch. Es wird ein Expertensystem herangezogen, das zur Erstellung einer dritten Bewertung eines Zustands der Batterie genutzt wird. Aus den im Betrieb der Batterie im Batteriemanagementsystem aufgezeichneten Betriebsdaten leitet das Expertensystem bekannte Phänomene und Zustände ab.

Die dritte Bewertung erfolgt anhand dessen, was aus einer Kombination aus über die Dauer des Betriebs der Batterie aufgezeichneten Betriebszuständen und/ oder einer Häufigkeit von über die Dauer des Betriebs der Batterie aufgezeichneten Betriebszuständen durch das Expertensystem mit Hilfe des Regelwerks ermittelbar ist: Im Regelwerk hinterlegte Muster, die durch diese Häufigkeiten und/ oder Kombinationen gekennzeichnet sind, werden mit einer aktuelle vorgefundenen Information eines Batteriemanagementsystems abgeglichen und bei einer Übereinstimmung erfolgt eine Bewertung entsprechend einer dem erkanntnen Muster zugeordneten Bewertung. Das Expertensystem leitet aus den vorliegenden Daten beispielsweise eine individuelle "ok"- oder "Risiko von Fehlern/Gefahren"-Empfehlung ab. Diese Risikobewertung wird insbesondere mit einem quantifizierten Risikowert ergänzt, der angibt, mit welcher Wahrscheinlichkeit bei der im Regelwerk hinterlegten Häufigkeit und/ oder Kombination von Betriebszuständen eine bestimmte Bewertung sich auch als richtig erwiesen hat. In Weiterbildungen werden die Betriebszustandsdaten in ein Simulationsmodell überführt und dieses ermittelt dann die Risikobewertung und den vermuteten Sicherheits- oder Nutzwert.

Das Regelwerk bildet Informationen über den Einfluss der Häufigkeit von Betriebszuständen, die eine Batterie während ihrer Lebensdauer eingenommen hat, und der Kombinationen von verschiedenen Betriebszuständen, die hintereinander eingenommen wurden, auf die Eintrittswahrscheinlichkeit von Gefährdungen ab. In vorteilhafter Weiterbildung wird auch die computergestützte Verarbeitung des optischen Datensatzes durch das Bildverarbeitungssystem durch das Regelwerk berücksichtigt. Insbesondere werden Schwellen, die zu einer dritten Bewertung als kritisch oder zur Wiederverwendung unbrauchbar führen, herabgesetzt, wenn zusätzlich aufgrund der bildbasierten Analyse eine Schwachstelle erkannt wird.

Ein computerimplementierter Mechanismus vergleicht den aus dem Batteriemanagementsystem ausgelesenen Betriebszustands-Datensatzes mit den gespeicherten Informationen und leitet Gefährdungseinstufungen ab. Beispielsweise erfolgt anschließend ein Ermitteln und Ausgeben einer Empfehlung zur Vorgehensweise beim Zerlegen der Batterie ebenfalls auf der Steuerungseinheit.

Das Verfahren erlaubt es, in einem automatisierten Prozess potenziell gefährliche Batterien zu identifizieren, ohne dabei menschlichen Experten oder eine manuelle Inspektion zu benötigen. Das Verfahren beruht vorteilhafterweise nicht nur auf den im Batteriemanagementsystem gespeicherten einzelnen Zuständen, also quasi einzelnen Momentaufnahmen des Zustands der Batterie im Betrieb, sondern betrachtet eine Historie der im Batteriemanagementsystem gespeicherten Zustände, nämlich die Häufigkeit und/ oder Kombination von Zuständen. Dies ermöglicht eine Erkennung von Risiko-behafteten Batterien, obwohl einzelne Zustände noch keine Fehlermeldung o.ä. im Batteriemanagementsystem verursacht haben oder verursachen würden. Zudem ist es auf vorteilhafte Weise unnötig, bei der Gefahreneinschätzung auf einen Menschen und dessen Fehleranfälligkeit vertrauen zu müssen, die aufgrund der Vielzahl der Daten, die im Batteriemanagementsystem aufgezeichnet werden, nicht zu vernachlässigen ist.

Gemäß einer Ausgestaltung ist das Regelwerk statisch hinterlegt. Das Regelwerk umfasst statisch alle Regeln, nach denen die Bewertung der Batterie in Hinblick auf eine weitere Handhabung, insbesondere Verwendung zu Verwertungszwecken wie Reparatur, Wiederverwendund, Zerlegung, Recycling usw. erfolgt. Das Regelwerk basiert auf Erfahrungswerten und Expertenwissen und wird über die Beobachtung einer Vielzahl von Zerlegungsprozessen aufgebaut.

Gemäß einer Ausgestaltung wird das Regelwerk regelmäßig aktualisiert oder erweitert. Beispielsweise werden neue Batterietypen in das Regelwerk aufgenommen oder es werden angepasste Bewertungen hinterlegt, die aufgrund andauernder Beobachtung erfolgter Handhabungsprozesse, insbesondere erfolgter Zerlegungen von Batterien, die auf Grundlage der erfindungsgemäßen Bewertung erfolgen, als Feedback an das Expertensystem übergeben werden. Das Regelwerk wird insbesondere regelmäßig über einen remote-update-service um neue Phänomene oder eine detailliertere Beschreibung bekannter Zustände erweitert.

Gemäß einer Ausgestaltung wird die Häufigkeit von während einer Betriebszeit erfolgten Schützoperationen für die Bewertung berücksichtigt. Beispielsweise stellen klemmende oder klebende Hauptschütze ein Risiko dar: bei sehr hoher Anzahl von Schütz-Operationen steigt das Risiko einer mechanischen Verklemmung. Wenn also beispielsweise die Anzahl der im Batteriemanagementsystem mitgezählten Schützoperationen einen gewissen Grenzwert übersteigt, wird die Batterie als "potenziell anfällig für Schaltfehler" eingestuft und beispielsweise als für die Wiederverwendung ungeeignet eingestuft. Insbesondere werden zusätzliche Informationen für die Bewertung herangezogen, wie beisielsweise hohe Stromstärken bei den Schützoperationen, die den Effekt verstärken.

Beispielsweise werden auch vorgeschädigte Hauptschütze aus dem Auslesen der Daten des Batteriemanagementsystems erkannt, die bei einer ungünstigen Kombination neuer Steuerbefehle zum Klemmen führen können und eine dauerhaft unter Hochspannung stehende Batterie bewirken können.

Gemäß einer Ausgestaltung wird die Kombination von während einer Betriebszeit eingenommenen Temperaturen, Ladezuständen und/ oder Überströmen für die Bewertung berücksichtigt. Beispielsweise wird eine Kombination aus Temperaturen, Ladezuständen und zurückliegenden Überströmen als ungünstig erkannt. Hat eine Batterie in der Vergangenheit häufiger als empfohlen einen zu hohen Strom eingeprägt bekommen, kann sie ein stark erhöhtes, latentes Risiko eines internen Kurzschlusses in sich tragen.

Beispielsweise kommt es bei zu höhen Ladeströmen bei geringer Temperatur zu einem "Plating". Bei hohen Strömen bei hoher Temperatur kann es intern zu Hotspots mit Beschädigung der Struktur kommen. Bei hohen Temperaturen in großer Häufigkeit kommt es beispielsweise vermehrt zur Elektrolyttrocknung, also einer beschleunigten Alterung.

Die Kombinations-Effekte sind unterschiedlich kritisch, wobei einige auf die Alterung wirken, andere auf das Gefahrenpotenzial.

Wenn darüber hinaus auch noch eine Über- oder Tiefentladung vorliegt, könnte dieses Risiko typspezifisch noch einmal erhöt sein.

Gemäß einer Ausgestaltung wird eine Häufigkeit von während einer Betriebszeit erfolgten Über- oder Tiefentladungen für die Bewertung berücksichtigt. So könnte beispielsweise eine Batterie tiefentladen oder ggf. sogar negativ über-entladen worden sein, so dass ein erhöhtes Risiko besteht, dass die Zellen bei einer versehentlichen erneuten Benutzung in Brand geraten. Dies wird durch eine entsprechend deutliche Risiko-Beurteilung und insbesondere Gefährdungskennzeichnung bei der Ausgabe der Bewertung berücksichtigt. Bei negativer Entladung mit Polaritätswechsel oder bei Unterschreiten einer Mindestspannung >0 V gilt die Batterie insbesondere als defekt. Zersetzungsvorgänge, die im Inneren begonnen haben, sind dann mit einem hohen Sicherheitsrisiko bei weiterer Verwendung verbunden. Bei leichteren Über- oder Tiefentladungen wird die Kombination aus Häufigkeit und Schwere von einem Modell bewertet.

Gemäß einer Ausgestaltung ist das Regelwerk herstellerspezifisch oder Batterietyp-spezifisch. Batterien sind insbesondere verschieden robust oder verschieben unempfindlich gegenüber extremen Beanspruchungen wie Tiefentladung oder Temperaturereignissen, beispielsweise Brand im Umfeld der Batterie o.ä. Dies kann durch das Expertensystem berücksichtigt werden, indem beispielsweise bei gleicher Logik unterschiedliche Grenzwerte je nach Batterietyp oder -Hersteller hinterlegt sind.

Gemäß einer Ausgestaltung wird ein machine-learning-basiertes Verfahren basierend auf überwachtem Lernen eingesetzt und eine weitere dritte Bewertung des Zustands der Batterie erstellt. Die Erkennung von Risiken oder Auffälligkeiten mittels des Regelwerk-basierten Expertensystems kann mittels maschinellen Lernens verstärkt werden.

Dafür wird ein machine-learning System mit gelabelten Daten angelernt. In einer Trainingsphase werden dafür dem machine-learning System Trainings-Daten, die Häufigkeiten und/ oder Kombinationen von Betriebszuständen beschreiben sowie eine diesen Charakteristika entsprechende in der Realität als korrekt erprobte Bewertung als sogenannte ground truth Daten übergeben und das System an diesen Daten trainiert. Die Daten sind mit Labels wie "gefährlich" bzw. "ungefährlich" oder "nicht wiederverwendbar" bzw. "wiederverwendbar" oder "nicht aufbereitbar" oder "aufbereitbar" etc. versehen. Dabei wird ein kritisches Label, also "gefährlich" oder "nicht wiederverwendbar" oder "nicht aufbereitbar" dann vergeben, wenn eine der Batterien bei oder nach der Zerlegung einen unerwünschten Zustand bis hin zu Bränden eingenommen hat. Dieses Ereignis wird dem lernenden System mitgeteilt und mit dem vorher ermittelten Foto/Scan verknüpft, so dass das selbstlernende System im Laufe der Zeit eine gut/schlecht Basis hat. Beispielsweise wird so ein machine-learning basiertes Verfahren umfassend trainiert, welches dann im realen Betrieb in einem der obigen Verfahren eingesetzt wird.

Insbesondere ist der Mechanismus auf der Steuerungseinheit selbstlernend und die Informationen über den Einfluss der Betriebszustände auf die Häufigkeit von Gefährdungen werden aus Erkenntnissen beim späteren Zerlegen abgeleitet. Insbesondere müssen die Erfahrungen oder physikalischen Zusammenhänge nicht oder für einen aktuelle Batterietyp dann nicht vorliegen.

Beispielsweise werden nach einer entsprechenden Anlernzeit auch Auffälligkeiten erkannt, die keine direkte physikalische Erklärung wie beispielsweise die gut dokumentierten Isolationsschäden haben oder ohne dass ein Fehlerpotenzial physikalisch erklärt werden kann. Solche Effekte werden beispielsweise erst durch eine große Anzahl untersuchter Batterien und entsprechend klassifizierter Datensätze, die als Trainingsdaten für das Trainieren des machine-learning basierten Verfahrens verwendet werden, durch den Betrieb des machine-learning basierten Verfahrens selbst erkannt.

Beispielsweise wird dazu das Risiko über Lernroutinen ermittelt. Zu jedem Batteriespeicherinhalt wird der Zustand aller einzelnen Parameter, insbesondere der State of Charge, SoC, der State of Health, SoH, etc. ausgelesen und abgespeichert. Wenn im Laufe der Zeit unerwünschter Weise einzelne Batterien während der Zerlegung Defekte aufweisen oder in gefährliche Zustände wechseln, können diese Ereignisse dem bereits gespeicherten Datensatz zugeordnet werden. Nach einer gewissen Zeit kann dann bei erneutem Auftreten des spezifischen Datenmusters eine Warnung ermittelt werden. Diese lernende Bewertung profitiert dabei besonders von Fuzzy-Methoden, bei denen auch nur "ungefähr ähnliche" Zustände in die Bewertung aufgenommen werden.

Es findet vorzugsweise ein kontinuierlich mitlernendes AI-Verfahren Anwendung, das die Daten aus dem laufenden Betrieb wiederum als Trainingsdaten verwendet. Beispielsweise wird ein neu-Lernen in einem vorgegebenen zeitlichen Abstand durchgeführt.

Das Verfahren erkennt dann Fälle, die einerseits nicht dem "ungefährlich"-Zustand aus der Trainingsphase zuzuordnen sind, die aber auch nicht den "gefährlich" gelabelten Daten entsprechen. Das aus der Trainingsphase angelernte Verfahren ist somit zu einer Mustererkennung für unbekannte Muster in den aufgezeichneten Daten des Batteriemanagementsystems im laufenden Betrieb fähig.

Somit erfolgt ein Training von Basisdaten auf Basis vieler vorheriger Messungen sowie sogenannten "ground truth"-Daten von Batterie-Komponenten im Neuzustand. Das Training verfeinert die Akzeptanzgrenzen, innerhalb welcher die Entscheidung des AI-Systems für eine bestimmte Bewertung erfolgt.

Gemäß einer Ausgestaltung erfolgt das machine-learning-basierte Verfahren unter Ausnutzung von Fuzzy-Logik-Methoden. So kann die lernende Beurteilung auch nur "ungefähr ähnliche" Zustände in die Bewertung aufnehmen.

Gemäß einer Ausgestaltung erfolgt das machine-learning-basierte Verfahren zusätzlich, insbesondere parallel oder nachgeschaltet, zur Erstellung der dritten Bewertung des Zustands der Batterie durch das Expertensystem und es erfolgt ein Ausgeben der dritten Bewertung sowie der weiteren dritten Bewertung des Zustands zum Ableiten der dritten Handlungsempfehlung.

Somit wird vorzugsweise das schnelle, berührungslose Verfahren basierend auf der dritten Bewertung durch das Expertensystem genutzt. Die dritte Bewertung wird anhand des Betriebszustands-Datensatzes auf dem vorgesehenen Weg bereitgestellt, vorzugsweise über HMI Geräte einer Steuerungseinheit oder einer Steuerung der Anlage, die für ein Batterie-Recycling genutzt wird. Zugleich wird das AI-System eingesetzt. Dies wird zeitlich parallel oder nachgeschaltet durchgeführt.

Dieses ermöglicht feinere Analysen und identifiziert insbesondere "false-positives", also irrtümlicherweise durch das Expertensystem auf Basis des Regelwerks als gefährlich eingestufte Batterien, und kennzeichnet diese für ein für die unkritischen Batterien geeignetes Recycling-Verfahren.

Ferner werden durch die AI-gestützten Analysen Muster in den Betriebszustands-Datensätzen erkannt, die nur aufgrund großer zu analysierender Datenmengen erkannt werden und bei Einsatz eines Bewertungssystems auf Basis des Regelwerks unerkannt blieben, da sie noch unbekannt sind und deshalb noch nicht in das Regelwerk eingegangen sind, oder da sie mit großen Varianzen auftreten, weil beispielsweise die Auswirkungen von Kombinationen an State of Health Daten und State of Charge Daten oder der Häufigkeit von Temperatur-Extremen von weiteren äußeren Faktoren abhängen, die eine Mustererkennung durch Experten, welche dem Regelwerk zugrunde liegen, erschweren.

Vorteilhafterweise ist die Analyse mittels der machine-learning basierten Verfahrens robust gegenüber geringen Schwankungen hinsichtlich der exakten Häufigkeit aufgetretener Ereignisse oder der Kombination von Ereignissen in der Historie des Batterie-Betriebszustands, was insbesondere durch Fuzzy-Mechanismen realisiert wird.

Es wird somit zusätzlich die weitere dritte Bewertung anhand des AI-Verfahrens ermittelt und ausgegeben. Eine erweiterte dritte Handlungsempfehlung berücksichtigt beide Bewertungen und gibt insgesamt die am wenigsten einschränkende zugleich noch als sicher eingestufte Empfehlung für eine weitere Handhabung der Batterie aus.

In Varianten wird auch die dritte Handlungsempfehlung rein auf Basis des Expertensystems mit dem Regelwerk ausgegeben, insbesondere um zu Zwecken der Dokumentation und Weiterentwicklung des Systems beide Bewertungen im Vergleich abzulegen. So wird beispielsweise Handlungsbedarf besonders leicht ersichtlich, wenn die AI-Bewertung zu oft von der Expertensystem-basierten Bewertung abweicht.

In Ausgestaltungen wird das AI basierte System für die Erstellung der weiteren Bewertung unter Berücksichtigung des optischen Datensatzes und die Erstellung der weiteren dritten Bewertung unter Berücksichtigung des Batteriemanagementdatensatzes genutzt und eine gemeinsame AI-Bewertung ausgegeben, die beide Informationen berücksichtigt, insbesondere, indem immer die kritischere Bewertung als gemeinsame AI-Bewertung für die Ableitung einer weiteren übernommen wird.

In Ausgestaltungen berücksichtigt die erweiterte dritte Handlungsempfehlung alle Bewertungen, die gemeinsame AI-Bewertung sowie die Bilddaten-basierte Bewertung und die dritte Batteriemanagement-basierte Bewertung.

Die Erfindung betrifft ferner eine Steuerungseinheit zur zustandsabhängigen Handhabung einer Batterie mit einem Erfassungsgerät und einem Bildverarbeitungssystem und einem Prozessor, ausgestaltet zum Ausführen des Verfahrens nach einem der vorstehend beschriebenen Ausgestaltungen.

Die Erfindung wird nachfolgend anhand von Ausführungsbeispielen mit Hilfe der Figuren näher erläutert. Es zeigen:
- FIG 1: eine schematische Darstellung einer Steuerungseinheit zur zustandsabhängigen Handhabung einer Batterie gemäß einem ersten Ausführungsbeispiel der Erfindung;
- FIG 2: eine schematische Darstellung eines Diagramms zur Veranschaulichung eines Verfahrens zur zustandsabhängigen Handhabung einer Batterie gemäß einem zweiten Ausführungsbeispiel der Erfindung.

In den Figuren sind funktionsgleiche Elemente mit denselben Bezugszeichen versehen, sofern nichts anderes angegeben ist.

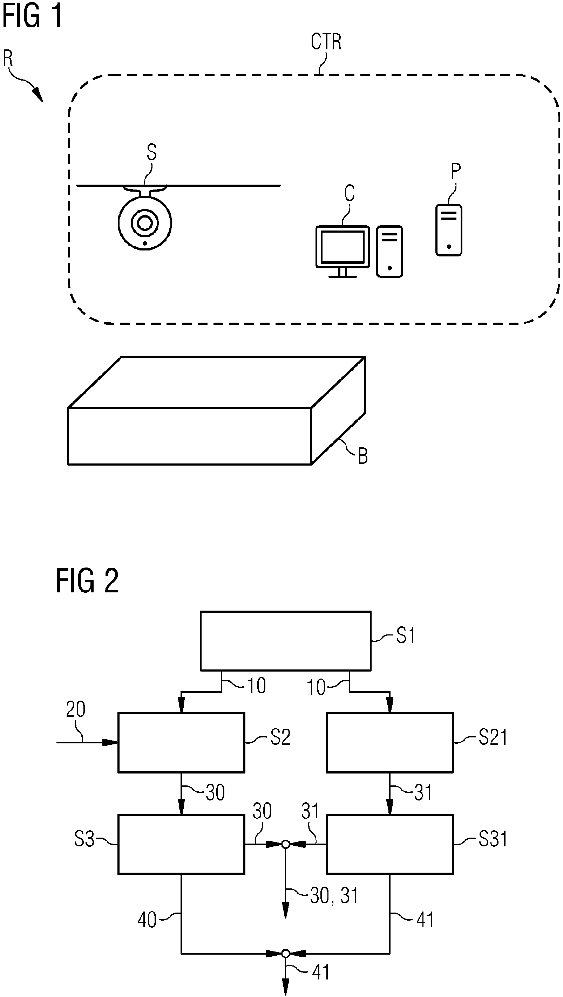

In Figur 1 ist eine Steuerungseinheit CTR gezeigt, die als Erfassungsgerät S eine Kamera aufweist, welche in einer Verwertungs- oder Recyclinganlage R für Batterien, insbesondere in einer automatisierten Verarbeitungszelle mit entsprechendem Logistik- und Handling-Equipment, insbesondere AGVs und Robotergreifarmen, installiert ist. Die Kamera S ist ausgebildet und eingerichtet, ein Bild einer in der Recyclinganlage R eintreffenden Batterie B aus verschiedenen Raumrichtungen aufzunehmen. Dafür ist beispielsweise die Kamera drehbar eingerichtet. In alternativen Ausgestaltungen wird die Batterie B mittels der Robotergreifarme verschieden positioniert, um Aufnahmen aus verschiedenen Perspektiven zu erhalten.

Die Kamera S liefert das Bildmaterial an ein Bildverarbeitungssystem C, welches beispielsweise über einen Speicher mit Referenzdatensätzen verfügt. Je nach eintreffendem Batterietyp, der dem Bildverarbeitungssystem C beispielsweise vorgegeben wird oder der mittels an der Batterie angebrachten Labeln, QR-Codes o.ä. für das Bildverarbeitungssystem eigenständig abrufbar ist, wird ein passender Referenzdatensatz ausgewählt oder angefragt. Beispielsweise wird dieser über eine Web-Anbindung ermittelt. Gerade vom Äußeren von Batterien ist eine große Anzahl an Bildmaterial verschiedener Batterietypen verfügbar.

Beispielsweise weist das Bildverarbeitungssystem C einen eigenen Prozessor auf, der den Abgleich des aufgenommenen Bildmaterials mit dem Referenzdatensatz vornimmt und anhand dessen die Bewertung des Zustands der Batterie vornimmt. Beispielsweise verfügt das Bildverarbeitungssystem auch über ein HMI, über das die Ausgabe der Bewertung des Zustands der Batterie B erfolgt. In alternativen Ausführungen ist ein separates HMI vorgesehen, welches zugleich Infos zu dem Erfassungssystem S, insbesondere Fehlermeldungen oder Einstellungen zu Fokus, Belichtung usw., zur Anzeige bringt oder welches das HMI eines separaten Prozessors einer Steuerung oder PLC der gesamten Automatisierungszelle ist.

Ein separater Prozessor P zur Ausgabe von Handlungsempfehlungen und ferner zur Steuerung von Handhabungen der Batterie B auf Basis der Handlungsempfehlung ist gemäß dem ersten Ausführungsbeispiel vorgesehen und abgebildet. Dessen Funktionalitäten sind je nach weiterer Ausgestaltung der Recyclinganlage R ausgebildet. In einfachen Ausführungen handelt es sich um ein Warnsystem, das über Ampelfarben an einer Leuchte innerhalb der Automatisierungszelle das Vorliegen einer Bewertung der Batterie als potentiell gefährlich oder das Vorliegen einer abgeleiteten Handlungsempfehlung anzeigt, die eine anschließende Weiterverarbeitung der Batterie unter besonderen Sicherheitsmaßnahmen empfiehlt.

Figur 2 veranschaulicht anhand eines Ablaufdiagramms ein Verfahren zur zustandsabhängigen Handhabung einer Batterie gemäß einem zweiten Ausführungsbeispiel. In einem ersten Schritt erfolgt eine berührungslose und optische Erfassung S1 einer Batterie in einem ungeöffneten Zustand durch ein Erfassungsgerät und eine Erstellung eines optischen Datensatzes 10.

Dieser optische Datensatz 10 wird zusammen mit einem Referenzdatensatz 20 zu Zwecken einer computergestützten Verarbeitung S2 einem Bildverarbeitungssystem übergeben. Als Ergebnis wird eine Bewertung 30 des Zustands der Batterie ausgegeben. Es erfolgt das Ausgeben S3 der Bewertung 30, beispielsweise zu Zwecken der Informationswiedergabe innerhalb eines Steuerungssystems einer Batterie-Recyclinganlage.

Der optische Datensatz 10 wird zudem auch einem machine-learning-basierten Programm übergeben, das zusätzlich eingesetzt wird S21, um ebenfalls rein aufgrund optischer Informationen über die ungeöffnete Batterie Aussagen über das Gefährdungspotential sowie die Tauglichkeit der Batterie zur weiteren Verwendung zu treffen. Es wird eine weitere Bewertung 31 der AI-basierten Analyse erstellt und ausgegeben S31.

Somit liegen für eine zu bewertende Batterie beide Analyseergebnisse, also beide Bewertungen 30, 31 vor.

Angelernt wurde das AI-System mit Trainingsdaten aus manuellen Analysen von Batterien von Experten oder vorzugsweise aus Analysen wie dem oben beschriebenen, das bereits die optische Analyse anhand der Referenzdaten durchführt, ergänzt um quasi eine Validierung aus dem Betrieb, also beispielsweise einer Korrektur in Fällen, in welchen die Bewertung 30 durch das Bildverarbeitungssystem eine Beschädigung der Batterie angezeigt hat, diese jedoch intakt war, oder anders herum.

Es wird gemäß dem zweiten Ausführungsbeispiel der Erfindung nur die abgeleitete Handlungsempfehlung 41 des AI-basierten Verfahrens ausgegeben. Diese wird zugleich für die weitere Handhabung und Verarbeitung der Batterie in der Anlage genutzt.

Beispielsweise erkennt das machine-learning basierte Verfahren eine Lichtbogenaufschmelzung aus einer Kamera-Aufnahme, obwohl aufgrund der Perspektive der Kamera keine Gehäuselöcher identifizierbar sind. Das Bildverarbeitungsverfahren wertet deshalb die erkannte Farbveränderung nicht als Lichtbogenaufschmelzung. Es gibt beispielsweise als Bewertung aus, dass keine Beschädigung erkannt wurde oder gibt einen Indikator aus, dass eine manuelle Kontrolle eines Experten erfolgen muss. Das machine-learning basierte Verfahren kommt mit der lückenhaften Information aufgrund des Kamerawinkels besser zurecht und gibt als Bewertung auf Basis der erkannten Lichtbogenaufschmelzung aus, dass eine beschädigte Batterie vorliegt.

## Patentansprüche

1. Verfahren zur zustandsabhängigen Handhabung einer Batterie (B), aufweisend folgende Schritte:
- berührungslose und optische Erfassung (S1) der Batterie (B) in einem ungeöffneten Zustand durch ein Erfassungsgerät (S) und Erstellung eines optischen Datensatzes (10),
- computergestützte Verarbeitung (S2) des optischen Datensatzes (10) durch ein Bildverarbeitungssystem (C) auf Basis eines Referenzdatensatzes (20) eines Äußeren der Batterie (B) zur Erstellung einer Bewertung (30) eines Zustands der Batterie (B),
- Ausgeben (S3) der Bewertung (30) des Zustands zum Ableiten einer Handlungsempfehlung (40) für die Handhabung der ungeöffneten Batterie (B).

2. Verfahren nach Anspruch 1, wobei das Erfassungsgerät (S) einen optischen Sensor, insbesondere eine Kamera, IR-Kamera oder einen 3D Laser Scanner aufweist.

3. Verfahren nach Anspruch 1 oder 2, wobei ein Metallgehäuse der Batterie (B) optisch erfasst wird und der optische Datensatz (10) abhängig von einer Eigenschaft des Metallgehäuses erstellt wird.

4. Verfahren nach einem der vorstehenden Ansprüche, wobei eine Verfärbung des Metallgehäuses erfasst wird.

5. Verfahren nach einem der vorstehenden Ansprüche, wobei eine lokale Aufschmelzung des Metallgehäuses erfasst wird.

6. Verfahren nach einem der vorstehenden Ansprüche, wobei eine geometrische Abmessung der Batterie (B), insbesondere des Gehäuses, erfasst wird.

7. Verfahren nach einem der vorstehenden Ansprüche, wobei eine Wölbung von Bereichen des Metallgehäuses erfasst wird.

8. Verfahren nach einem der vorstehenden Ansprüche, wobei der Referenzdatensatz (20) des Äußeren der Batterie (B) als eine Datenbank mit Fotos, Kameradaten, Skizzen, über Simulation generierten Bilddaten, 3D-Daten, CAD-Daten und/oder Farbtabellen ausgestaltet ist.

9. Verfahren nach einem der vorstehenden Ansprüche, wobei ein machine-learning-basiertes Verfahren basierend auf überwachtem Lernen eingesetzt wird (S21) und eine weitere Bewertung (31) des Zustands der Batterie (B) erstellt wird.

10. Verfahren nach einem der vorstehenden Ansprüche, wobei das machine-learning-basierte Verfahren zusätzlich, insbesondere parallel oder nachgeschaltet, zur Erstellung der Bewertung (30) des Zustands der Batterie (B) durch das Bildverarbeitungssystem (C) erfolgt und ein Ausgeben (S3, S31) der Bewertung (30) sowie der weiteren Bewertung (31) des Zustands zum Ableiten einer erweiterten Handlungsempfehlung (41) erfolgt.

11. Verfahren nach einem der vorstehenden Ansprüche, wobei ferner folgende Schritte ausgeführt werden:
- Erfassung eines mittels eines Batteriemanagementsystems gespeicherten Betriebszustands-Datensatzes der Batterie (B),
- computergestützte Verarbeitung des Betriebszustands-Datensatzes durch ein Expertensystem zur Erstellung einer dritten Bewertung eines Zustands der Batterie (B), wobei die dritte Bewertung in Abhängigkeit von einer Häufigkeit und/ oder Kombination von Betriebszuständen und einem Regelwerk erstellt wird,
- Ausgeben der dritten Bewertung des Zustandes zum Ableiten einer dritten Handlungsempfehlung für eine Handhabung der Batterie (B).

12. Steuerungseinheit (CTR) zur zustandsabhängigen Handhabung einer Batterie (B) mit einem Erfassungsgerät (S) und einem Bildverarbeitungssystem (C) und einem Prozessor (P), ausgestaltet zum Ausführen des Verfahrens nach einem der vorstehenden Ansprüche.
